# EUROPEAN PATENT APPLICATION

(11) **EP 4 354 485 A1**
(43) Date of publication of application: **17.04.2024**
(21) Application number: 22201416.9
(22) Date of filing: 13.10.2022
(51) Int. Cl.: H01J 37/22, H01J 37/28, G01R 31/00

(54) **CHARGED PARTICLE-OPTICAL APPARATUS**

(71) Applicant: ASML Netherlands B.V., 5500 AH Veldhoven (NL)
(72) Inventor: WIELAND, Marco, Jan-Jaco, 5500 AH Veldhoven (NL)
(74) Representative: ASML Netherlands B.V.

(57) **Abstract**

A charged particle-optical apparatus for assessing a sample at an assessment location, the charged particle-optical apparatus comprising: an assessment charged particle-optical device configured to project an assessment charged particle beam along an assessment beam path toward an assessment location, the assessment charged particle beam for assessing a sample at the assessment location; a preparatory charged particle-optical device configured to project a preparatory charged particle beam along a preparatory beam path, the preparatory charged particle beam for preparing a sample for assessment; and a light source configured to project a light beam toward an illumination location; wherein a locational relationship between the illumination location and the assessment charged particle-optical device is different from a locational relationship between the assessment location and the assessment charged particle-optical device.

## Description

### FIELD

The embodiments provided herein generally relate charged particle-optical apparatuses and methods for assessing a sample.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscatter electrons or Auger electrons, which may be referred to as signal particles. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample. The intensity of the electron beams comprising the backscatter electrons and the secondary electrons may vary based on the properties of the internal and external structures of the sample, and thereby may indicate whether the sample has defects.

When the primary electron beam scans the sample, charges may be accumulated on the sample due to large beam current, which may affect the quality of the image. The material structure may be illuminated with light and/or flooded with electrons in order to improve the defect contrast during defect inspection. For example, to regulate the accumulated charges on the sample, an Advanced Charge Controller (ACC) module may be employed to illuminate a light beam, such as a laser beam, on the sample, so as to control the accumulated charges due to effects such as photoconductivity, photoelectric, or thermal effects. The term ACC is used in the description below as shorthand for illumination by a light beam. It is to be understood that the term ACC refers generally to illumination by a light beam. It can be difficult to illuminate the light beam on the sample. For example, the dimensions of the pattern inspection tool may make it difficult to reach the sample with the light beam.

### SUMMARY

It is an object of the present disclosure to provide embodiments that support increasing the amount of light irradiated onto a sample for assessments involving improved defect contrast.

According to a first aspect of the invention, there is provided a charged particle-optical apparatus for assessing a sample at an assessment location, the charged particle-optical apparatus comprising: an assessment charged particle-optical device configured to project an assessment charged particle beam along an assessment beam path toward an assessment location, the assessment charged particle beam for assessing a sample at the assessment location; a preparatory charged particle-optical device configured to project a preparatory charged particle beam along a preparatory beam path, the preparatory charged particle beam for preparing a sample for assessment; and a light source configured to project a light beam toward an illumination location; wherein a locational relationship between the illumination location and the assessment charged particle-optical device is different from a locational relationship between the assessment location and the assessment charged particle-optical device.

According to a second aspect of the invention, there is provided a charged particle-optical apparatus for assessing a sample at an assessment location, the charged particle-optical apparatus comprising: an assessment charged particle-optical device configured to project an assessment charged particle beam along an assessment beam path toward an assessment location, the assessment charged particle beam for assessing a sample at the assessment location; a preparatory charged particle-optical device configured to project a preparatory charged particle beam along a preparatory beam path, the preparatory beam for preparing a sample for assessment; a light source configured to project a light beam toward the sample at an illumination location away from the assessment location.

According to a third aspect of the invention, there is provided a method for assessing a sample at an assessment location, the method comprising: projecting with a preparatory charged particle-optical device a preparatory charged particle beam along a preparatory beam path, the preparatory charged particle beam for preparing a sample for assessment; projecting a light beam toward the sample at an illumination location; and projecting with an assessment charged particle-optical device an assessment charged particle beam along an assessment beam path toward the sample at an assessment location, the assessment charged particle beam for assessing the sample at the assessment location; wherein a locational relationship between the illumination location and the assessment charged particle-optical device is different from a locational relationship between the assessment location and the assessment charged particle-optical device.

According to a fourth aspect of the invention, there is provided a method for assessing a sample at an assessment location, the method comprising: projecting with a preparatory charged particle-optical device a preparatory charged particle beam along a preparatory beam path, the preparatory charged particle beam for preparing a sample for assessment; projecting a light beam toward the sample at an illumination location; and projecting with an assessment charged particle-optical device an assessment charged particle beam along an assessment beam path toward the sample at an assessment location, the assessment charged particle beam for assessing the sample at the assessment location; wherein the light beam is projected toward the sample at the illumination location when the sample is away from the assessment location.

According to a fifth aspect of the invention, there is provided a method for assessing a sample at an assessment location, the method comprising: projecting a preparatory charged particle beam toward a sample for preparing the sample for assessment; projecting a light beam toward the sample; and projecting an assessment charged particle beam along an assessment beam path toward the sample at an assessment location for assessing the sample at the assessment location; wherein the projecting of the light beam is before the sample is at the assessment location.

According to a sixth aspect of the invention, there is provided a charged particle-optical apparatus for assessing a sample at an assessment location, the charged particle-optical apparatus comprising: an assessment charged particle-optical device configured to project an assessment charged particle beam along an assessment beam path toward an assessment location, the assessment charged particle beam for assessing a sample at the assessment location; and a preparatory charged particle-optical device configured to project a preparatory charged particle beam along a preparatory beam path, the preparatory charged particle beam for preparing a sample for assessment; wherein the assessment charged particle-optical device comprises one or more charged particle-optical elements which comprise a microelectromechanical component and/or an objective lens comprising a plurality of objective lenses for different beams of the assessment charged particle beam.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam inspection apparatus.
**FIG. 2** is a schematic diagram illustrating an exemplary multi-beam electron-optical apparatus that is part of the exemplary electron beam inspection apparatus of **FIG. 1****.**
**FIG. 3** is a schematic diagram of an exemplary multi-beam electron-optical apparatus.
**FIG. 4** is a schematic diagram of an exemplary electron-optical apparatus comprising a macro collimator and macro scan deflector.
**FIG. 5** is a schematic diagram of an exemplary multi-beam electron-optical apparatus according to an embodiment.
**FIG. 6** is a schematic diagram of part of the multi-beam electron-optical apparatus of **FIG. 5****.**
**FIG. 7** is a schematic cross-sectional view of an objective lens array of an electron-optical apparatus according to an embodiment.
**FIG. 8** is a bottom view of a modification of the objective lens array of **FIG. 7****.**
**FIG. 9** is an enlarged schematic cross-sectional view of a detector incorporated in the objective lens array of **FIG. 7****.**
**FIG. 10** is a bottom view of a detector element of a detector.
**FIG. 11** is a schematic diagram of the exemplary electron-optical apparatus according to an embodiment.
**FIG. 12** is a schematic diagram of an exemplary electron-optical apparatus according to an embodiment.
**FIG. 13** is a schematic diagram of an exemplary assessment electron-optical apparatus according to an embodiment.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally considered to be references to charged particles, with the charged particles not necessarily being electrons. For example, reference to an electron-optical apparatus may be more generally considered to be reference to a charged particle apparatus.

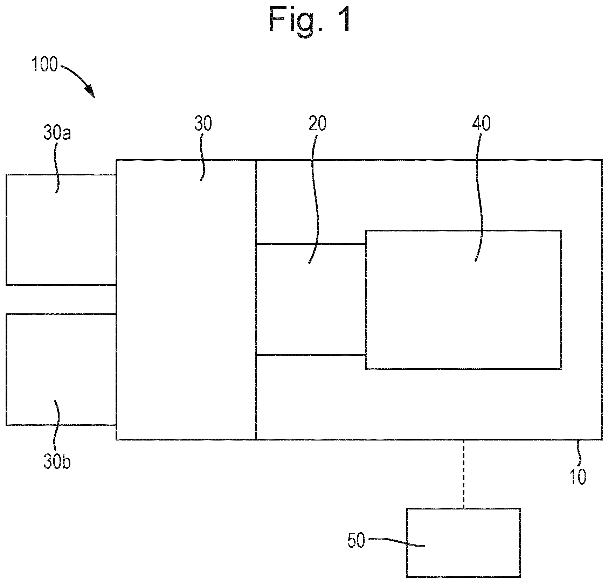

Reference is now made to **FIG. 1****,** which is a schematic diagram illustrating an exemplary electron beam inspection apparatus 100. The electron beam inspection apparatus 100 of **FIG. 1** includes a main chamber 10, a load lock chamber 20, an electron-optical apparatus 40 (which may also be called an electron assessment apparatus or an electron beam system or tool), an equipment front end module (EFEM) 30 and a controller 50. The electron-optical apparatus 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron-optical apparatus 40 by which it may be inspected. The electron-optical apparatus 40 comprises an electron-optical device 41 (which may be referred to as a charged particle device). The electron-optical device 41 may be an electron-optical column configured to project at least one electron beam towards the sample 208, and/or an objective lens module configured to focus at least one electron beam onto the sample 208. The electron-optical device 41 may also comprise a detector module configured to detect electrons emitted from the sample 208, and/or a control lens module configured to adjust an electron-optical parameter of at least one electron beam. In an embodiment the electron-optical column may comprise the objective lens module and the detector module and optionally the control lens module. In an embodiment the electron-optical device comprises an objective lens assembly which may be comprised in the electron-optical column. The objective lens assembly comprises an objective lens array associated with (e.g. integrated with) one or more other electron-optical components such as a detector array and optionally a control lens array. The electron-optical device 41 may be a multi-beam electron-optical device 41 for a multi-beam projected towards the sample 208. In an embodiment the electron-optical device 41 comprises multi-devices (or columns) comprising a plurality of electron-optical devices configured to project respective electron beam or electron multi-beams towards the sample 208.

The controller 50 is electronically connected to electron-optical components of the electron-optical device 41 of the electron-optical apparatus 40. The controller 50 may be a processor (such as a computer) configured to control the electron beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the electron beam inspection apparatus 100 or it can be distributed over at least two of the component elements. The controller may be considered to be part of the electron-optical device 41. While the present disclosure provides examples of the main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

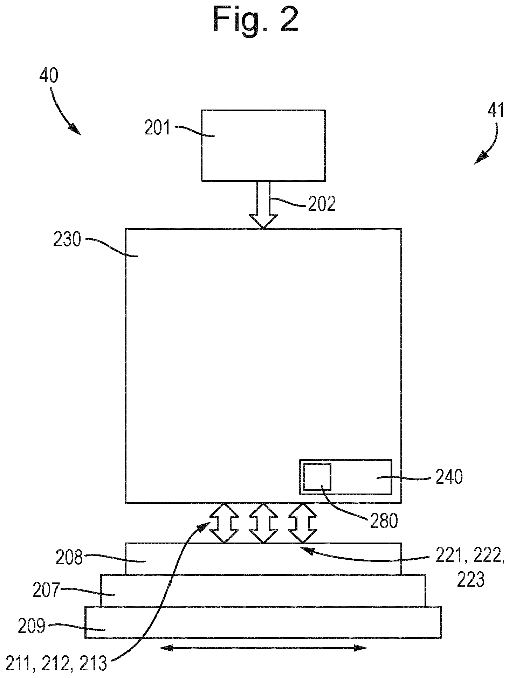

Reference is now made to **FIG. 2****,** which is a schematic diagram illustrating an exemplary electron-optical apparatus 40 including a multi-beam electron-optical device 41 that is part of the exemplary electron beam inspection apparatus 100 of **FIG. 1****.** The multi-beam electron-optical device 41 comprises an electron source 201 and a projection apparatus 230. The electron-optical apparatus 40 further comprises a motorized stage 209 and a sample holder 207. The projection apparatus 230 may be referred to as the electron-optical device 41. The sample holder 207 is supported by motorized stage 209 so as to hold a sample 208 (e.g., a substrate or a mask) for inspection. The multi-beam electron-optical device 41 may further comprise a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary assessment electron beam 202. The electron source 201 may comprise multiple sources, such as described in EP20184161.6, which is hereby incorporated by reference at least with respect to the multiple sources and how they relate to multiple columns and their associated electron-optics.

The projection apparatus 230 is configured to convert the primary assessment electron beam 202 into a plurality of assessment sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the electron beam inspection apparatus 100 of **FIG. 1****.** The controller 50 may be connected to various parts of the electron-optical apparatus 40 of **FIG. 2****,** such as the electron source 201, the detector 240, the projection apparatus 230, and the motorized stage 209 (or actuated stage). The controller 50 may perform various data, image and/or signal processing functions. The controller 50 may also generate various control signals to govern operations of the electron beam inspection apparatus 100, including the multi-beam electron-optical apparatus 40.

The projection apparatus 230 may be configured to focus assessment sub-beams 211, 212, and 213 onto a sample 208 for inspection and may form three probe spots 221, 222, and 223 on the surface of sample 208. The projection apparatus 230 may be configured to deflect the assessment sub-beams 211, 212, and 213 to scan the probe spots 221, 222, and 223 across individual scanning areas in a section of the surface of the sample 208. In response to incidence of the assessment sub-beams 211, 212, and 213 on the probe spots 221, 222, and 223 on the sample 208, signal charged particles (e.g. signal electrons) are generated (i.e. emitted) from the sample 208 which include secondary signal particles and backscatter signal particles. The signal particles emitted from the sample, e.g. secondary electrons and backscatter electrons, may otherwise be referred to as charged particles, e.g. secondary charged particles and backscatter charged particles. Signal beams are formed of signal particles emitted from the sample. It will generally be understood that any signal beams emitted from the sample 208 will travel in a direction with at least a component substantially opposite to the charged particle beams (i.e. the primary beams), or will have at least a component of direction which is opposite to the direction of the primary beams. Signal particles, which are emitted by the sample 208 may also pass through the electrodes of the objective lens and would also be affected by the field.

The secondary electrons typically have electron energy ≤ 50 eV. Actual secondary electrons can have an energy of less than 5 eV, but anything beneath 50 eV is generally treated at a secondary electron. Backscatter electrons typically have electron energy between 0 eV and the landing energy of the assessment sub-beams 211, 212, and 213. As electrons detected with an energy of less than 50 eV is generally treated as a secondary electron, a proportion of the actual backscatter electrons will be counted as secondary electrons. The secondary signal particles may more specifically be referred to, and are interchangeable with, secondary electrons. The backscatter signal particles may more specifically be referred to, and are interchangeable with, backscatter electrons. The skilled person would understand that the backscatter signal particles may more generally be described as secondary signal particles. However, for the purposes of the present disclosure, the backscatter signal particles are considered to be different from the secondary signal particles, e.g. having higher energies. In other words, the secondary signal particles will be understood to be particles having kinetic energy ≤ 50 eV when emitted from the sampled and the backscatter signal particles will be understood to be particles having kinetic energy higher than 50 eV when emitted from the sample. In practice, the signal particles may be accelerated before being detected and thus, the energy range associated with the signal particles may be slightly higher. For example, the secondary signal particles will be understood to be particles having kinetic energy ≤ 200 eV when detected at a detector and the backscatter signal particles will be understood to be particles having kinetic energy higher than 200 eV when detected at a detector. It is noted that the 200 eV value may vary depending on the extent of acceleration of the particles, and may for example be approximately 100 eV or 300 eV. Secondary signal particles having such values are still considered to have sufficient energy different with respect to the backscatter signal particles.

The detector 240 is configured to detect (e.g. capture) signal particles such as secondary electrons and/or backscatter electrons and to generate corresponding signals which are sent to a signal processing system 280, e.g. to construct images of the corresponding scanned areas of sample 208. The detector 240 may be incorporated into the projection apparatus 230. The detector array may otherwise be referred to as a sensor array, and the terms "detector" and "sensor" and "sensor unit" are used interchangeably throughout the application.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam electron-optical apparatus 40 such as the detector 240 (as shown in **FIG. 2****).** However, the signal processing system 280 may be incorporated into any components of the electron beam inspection apparatus 100 or multi-beam electron-optical apparatus 40, such as, as part of the projection apparatus 230 or the controller 50. The signal processing system 280 could be located outside of the structure that includes the main chamber which is shown in **FIG. 1****.** The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of assessment sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

The controller 50 may control the motorized stage 209 to move sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

Known multi-beam systems, such as the electron-optical apparatus 40 and electron beam inspection apparatus 100 described above, are disclosed in US2020118784, US20200203116, US 2019/0259570 and US2019/0259564 which are hereby incorporated by reference.

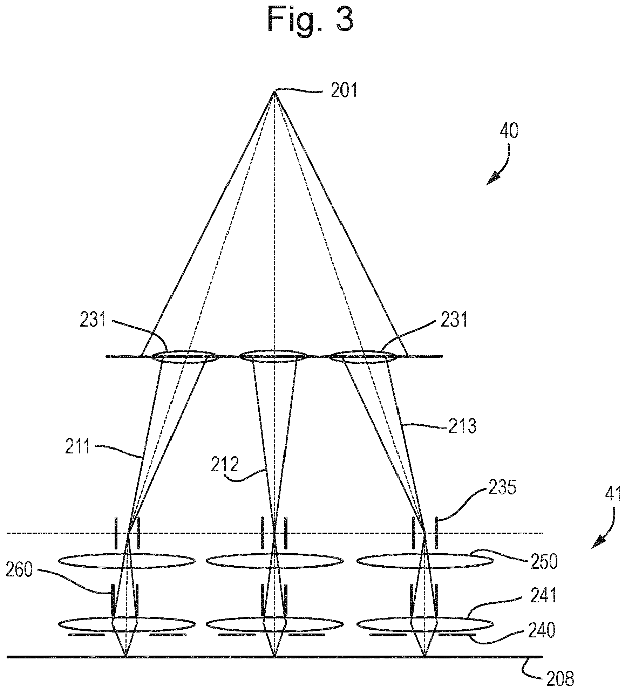

Components of an electron-optical apparatus 40 which may be used in the present invention are described below in relation to **FIG. 3** which is a schematic diagram of an electron-optical apparatus 40. The electron-optical apparatus 40 of **FIG. 3** may correspond to the electron-optical apparatus 40 (which may also be referred to as a system or a tool) mentioned above.

The electron source 201 directs electrons toward an array of condenser lenses 231 (otherwise referred to as a condenser lens array). The electron source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an electron beam, for example from the source, into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect. More generally, the condenser lenses 231 may have two or more plate electrodes each with an array of apertures that are aligned. Each plate electrode array is mechanically connected to, and electrically isolated from, an adjacent plate electrode array by an isolating element, such as a spacer which may comprise ceramic or glass. The condenser lenses may be connected and/or spaced apart from an adjacent charged particle-optical element, preferably an electrostatic charged particle-optical element, by an isolating element such as a spacer as described elsewhere herein.

The condenser lenses may be separated from a module containing the objective lenses (such as an objective lens array assembly as discussed elsewhere herein). In a case where the potential applied on a bottom surface of the condenser lenses is different than the potential applied on the top surface of the module containing the objective lenses an isolating element (e.g. a spacer) is used to space apart the condenser lenses and the module containing the objective lenses. In a case where the potential is equal then a conductive element can be used to space apart the condenser lenses and the module containing the objective lenses.

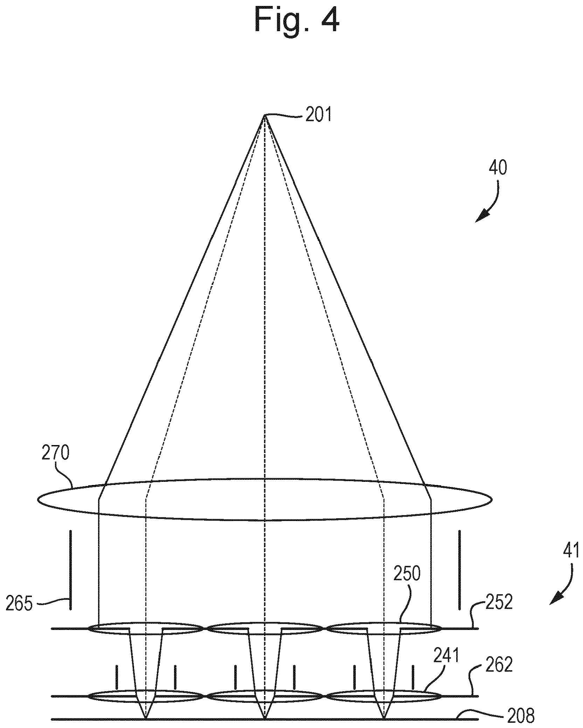

Each condenser lens 231 in the array directs electrons into a respective assessment sub-beam 211, 212, 213 which is focused at a respective intermediate focus down beam of the condenser lens array. The respective sub-beams are projected along respective sub-beam paths 220. The sub-beams diverge with respect to each other. The sub-beam paths 220 diverge down beam of the condenser lenses 231. In an embodiment, deflectors 235 are provided at the intermediate focuses. The deflectors 235 are positioned in the sub-beam paths at, or at least around, the position of the corresponding intermediate focuses 233 or focus points (i.e. points of focus). The deflectors 235 are positioned in or close to the sub-beam paths at the intermediate image plane of the associated sub-beam. The deflectors 235 are configured to operate on the respective assessment sub-beams 211, 212, 213. The deflectors 235 are configured to bend a respective assessment sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Down beam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. The collimator may comprise a macro collimator 270 (e.g. as shown in **FIG. 4****),** instead of, or in addition to the deflectors 235. Thus, the macro-collimator 270 described below in relation to **FIG. 4** may be provided with the features of **FIG. 3****.** This is generally less preferred than providing the collimator array as deflectors 235.

Below (i.e. down beam or further from electron source 201) the deflectors 235 there is a control lens array 250. The assessment sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

In further detail, it is desirable to use the control lens array 250 to determine the landing energy. However, it is possible to use in addition the objective lens array 241 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location, for example in, on or otherwise associated with the objective lens. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least one electrode, preferably two electrodes (e.g. two or three electrodes) connected to respective potential sources. The control lens array 250 may comprise one or more (e.g. three) plate electrode arrays connected to respective potential sources. The control lens array electrodes may be spaced a few millimeters (e.g. 3mm) apart. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned up-beam of the objective lens array 241. Up-beam may be defined as being closer to the source 201. Up-beam may otherwise be defined as further from the sample 208. The control lens array 250 may be in the same module as an objective lens array 241, i.e. forming an objective lens array assembly or objective lens arrangement, or it may be in a separate module. In this case, the arrangement may be described as four or more lens electrodes that are plates. In the plates are defined apertures, for example as aperture arrays, that are aligned with a number of sub-beams in a corresponding beam array. The electrodes may be grouped into two or more electrodes, for example to provide a control electrode group, and an objective electrode group. In an arrangement the objective electrode group has at least three electrodes and the control electrode group has at least two electrodes. Alternatively, if the control lens array 250 and the objective lens array 240 are separate, the spacing between the control lens array 241 and the objective lens array 250 (i.e. the gap between lower electrode of the control lens array 250 and the upper electrode of the objective lens 241) can be selected from a wide range, e.g. from 2 mm to 200 mm or more. A small separation makes alignment easier whereas a larger separation allows a weaker lens to be used, reducing aberrations.

Each plate electrode of the control lens array 250 is preferably mechanically connected to, and electrically separated from, an adjacent plate electrode array by an isolating element, such as a spacer which may comprise ceramic or glass. Each plate electrode of the objective lens array is preferably mechanically connected to, and electrically separated from, an adjacent plate electrode array by an isolating element, such as a spacer which may comprise ceramic or glass. The isolating element may otherwise be referred to as an insulating structure, and may be provided to separate any adjacent electrodes provided, such as in the objective lens array 240, the condenser lens array (as depicted in **FIG. 3****)** and/or the control lens array 250. If more than two electrodes are provided, multiple isolating elements (i.e. insulating structures) may be provided. For example, there may be a sequence of insulating structures.

The control lens array 250 may be considered as one or more electrodes additional to the electrodes of the objective lens array 241. The control lens array 250 provides extra degrees of freedom for controlling the sub-beams. A greater number of electrodes comprised in the control lens array 250 provides a greater number of degrees of freedom. For example, these extra electrodes may permit landing energy and/or magnification control independent of the field strength of the objective lens array 241. In some designs the control lens may thus be part of the objective lens. Reference to such electrodes may thus be as part of the objective lens rather than a separate lens such as a control lens. Reference to a control lens in such an arrangement is reference to functionally equivalent electrodes of the objective lens.

The control lens array 250 comprises a control lens for each assessment sub-beam 211, 212, 213. A control lens adds optical degrees of freedom to the function of the associated objective lens. A control lens may comprise of one or more electrode or plates. The addition of each electrode may provide a further degree of freedom of the control of the charged particle-optical function of the associated objective lens. In an arrangement the function of the control lens array 250 is to optimize the beam opening angle with respect to the demagnification of the beam and/or to control the beam energy delivered to the objective lenses, each of which directs a respective assessment sub-beam 211, 212, 213 onto the sample 208. The objective lens array 241 may be positioned at or near the base of the electron-optical system 41. More specifically, the objective lens array may be positioned at or near the base of the projection system 230. The control lens array 250 is optional, but is preferred for optimizing a sub-beam upbeam of the objective lens array 241.

For ease of illustration, lens arrays are depicted schematically herein by arrays of oval shapes (as shown in **FIG. 3****).** Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally, an array of scan deflectors 260 is provided between the control lens array 250 and the array of objective lenses 234. The array of scan deflectors 260 comprises a scan deflector for each assessment sub-beam 211, 212, 213. Each scan deflector is configured to deflect a respective assessment sub-beam 211, 212, 213 in one or two directions so as to scan the sub beam across the sample 208 in one or two directions.

**FIG. 4** is a schematic diagram of an exemplary electron-optical apparatus 40 comprising a macro collimator 270 and macro scan deflector 265. The electron source 201 directs electrodes toward a macro collimator 270. The electron source 201 is desirably a high brightness thermal field emitter with a good compromise between brightness and total emission current.

Sub-beams may be derived from the beam, for example, using a sub-beam forming array 252 (also known as a beam limiting aperture array) defining an array of beam-limiting apertures. The beam may separate into the sub-beams on meeting the control lens array 250, described below. The sub-beams are substantially parallel on entry to the control lens array 250.

The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). Thus the path of each sub-beam is at least intended to be orthogonal to the surface of the sample 208. The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

In another arrangement (not shown), the macro collimator 270 may be partially or wholly replaced by a collimator element array provided down-beam of the sub-beam forming array. Each collimator element collimates a respective sub-beam. The collimator element array may be formed using MEMS manufacturing techniques so as to be spatially compact. The collimator element array may be the first deflecting or focusing electron-optical array element in the beam path down-beam of the source 201. The collimator element array may be up beam of the control lens array 250. The collimator element array may be in the same module as the control lens array 250.

As shown in **FIG. 4****,** in an embodiment the electron-optical device 41 comprises an objective lens array 241. The objective lens array 241 comprises a plurality of objective lenses. The objective lens array 241 may be an exchangeable module. The exchangeable module may feature other electron-optical elements such as a detector array and/or a control lens array.

Below (i.e. down beam or further from the electron source 201) the macro collimator 270 there is a control lens array 250. The control lens array 250 is configured to apply a focusing action to the sub-beams prior to the sub-beams reaching the objective lens array. The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. Additionally or alternatively, the control lenses in the control lens array 250 are configured to control the opening angle of the sub-beams and/or to control demagnification (i.e. magnification) of the sub-beams and/or to control landing energy.

The control lens array 250 may be as described above in relation to **FIG. 3****.** The control lens array 250 may be considered as one or more electrodes additional to the electrodes of the objective lens array 241. The control lens array 250 provides extra degrees of freedom for controlling the sub-beams. A greater number of electrodes comprised in the control lens array 250 provides a greater number of degrees of freedom. For example, these extra electrodes may permit landing energy and/or magnification control independent of the field strength of the objective lens array 241. In some designs the control lens may thus be part of the objective lens. Reference to such electrodes may thus be as part of the objective lens rather than a separate lens such as a control lens.

The control lens array 250 comprises a control lens for each assessment sub-beam 211, 212, 213. A function of the control lens array 250 is to optimize the beam opening angle with respect to the demagnification of the beam and/or to control the beam energy delivered to the objective lens array 241 which directs the assessment sub-beams 211, 212, 213 onto the sample 208. The objective lens array 241 may be positioned at or near the base of the electron-optical device 41. The control lens array 250 is preferred for optimizing a sub-beam up-beam of the objective lens array 241.

In the embodiment of **FIG. 4** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector 265 may be partially or wholly replaced by a scan deflector array. The scan deflector array comprises a plurality of scan deflectors. The scan deflector array may be formed using MEMS manufacturing techniques. Each scan deflector scans a respective sub-beam over the sample 208. The scan-deflector array may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be up beam of an objective lens array 241. The scan deflector array may be down beam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array together, preferably in synchronization.

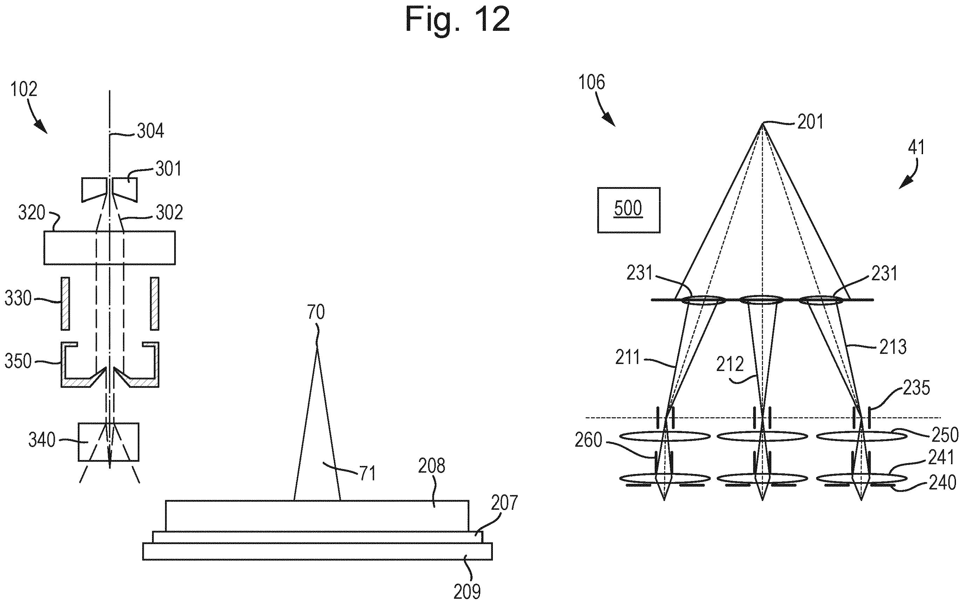

In some embodiments, the electron-optical device 41 further comprises a sub-beam forming array 252. The sub-beam forming array 252 defines an array of beam-limiting apertures. The sub-beam forming array 252 may be referred to as an upper beam-limiting aperture array or up-beam beam-limiting aperture array. The sub-beam forming array 252 may comprise a plate (which may be a plate-like body) having a plurality of apertures. The sub-beam forming array 252 forms sub-beams from a beam of electrons emitted by the source 201. Portions of the beam other than those contributing to forming the sub-beams may be blocked (e.g. absorbed) by the sub-beam forming array 252 so as not to interfere with the sub-beams down-beam. The sub-beam forming array 252 may be referred to as a sub-beam defining aperture array or an upper beam limiter. The apertures of the sub-beam forming array 252 may have a diameter 72 (see **FIG. 12****)** of at least 20 µm, optionally at least 50 µm, optionally at least 100 µm, and optionally 120 µm. The apertures have a pitch that may by equal to that of the apertures of the beam apertures 406.

In some embodiments, as exemplified in **FIG. 4****,** the electron-optical device 41 is an objective lens array assembly (which is a unit that comprises the objective lens array 241) and comprises a beam shaping aperture array 262. The beam shaping aperture array 262 defines an array of beam-limiting apertures. The beam shaping aperture array 262 may be referred to as a lower beam limiter, lower beam-limiting aperture array or final beam-limiting aperture array. The beam shaping aperture array 262 may comprise a plate (which may be a plate-like body) having a plurality of apertures. The beam shaping aperture array 262 may be down-beam from at least one electrode (optionally from all electrodes) of the control lens array 250. In some embodiments, the beam shaping aperture array 262 is down-beam from at least one electrode (optionally from all electrodes) of the objective lens array 241.

In an arrangement, the beam shaping aperture array 262 is structurally integrated with an electrode of the objective lens array 241. Desirably, the beam shaping aperture array 262 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping aperture array 262 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

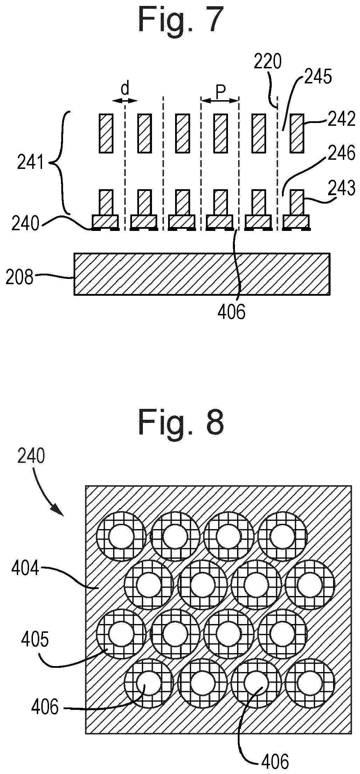

Any of the electron-optical apparatuses 40 described herein may further comprise a detector 240. The detector 240 detects signal particles, such as electrons, emitted from the sample 208. The detected electrons may include any of the electrons detected by an SEM, including secondary and/or backscatter electrons emitted from the sample 208. An exemplary construction of a detector 240 is shown in **FIG. 7** and described in more detail below with reference to **FIGs. 8-10****.**

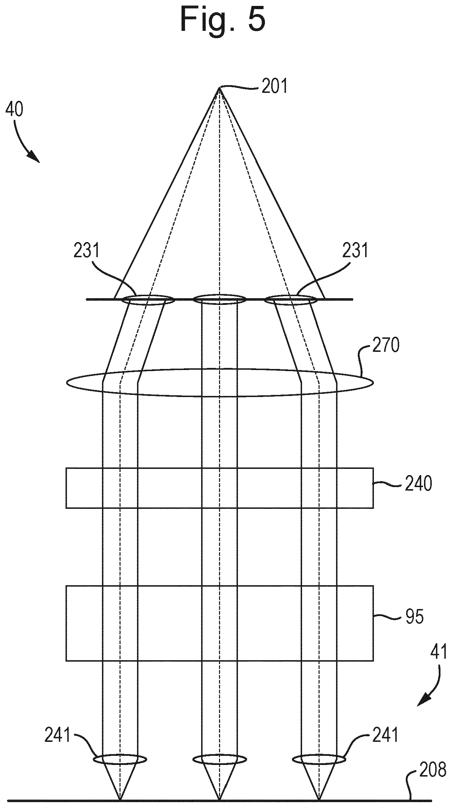

**FIG. 5** schematically depicts an electron-optical apparatus 40 according to an embodiment. Features that are the same as those described above are given the same reference numerals. For conciseness, such features are not described in detail with reference to **FIG. 5****.** For example, the source 201, the macro collimator 270, the objective lens array 241 and the sample 208 may be as described above.

In an embodiment the electron-optical apparatus 40 comprises an array condenser lenses 231. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which electrons have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

As described above, in an embodiment the detector 240 is between the objective lens array 241 and the sample 208. The detector 240 may face the sample 208. Alternatively, as shown in **FIG. 5****,** in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter so that deflector array may be referred to as a beam separator. The deflector array 95 is configured to provide a magnetic field to disentangle the electrons projected to the sample 208 from the secondary electrons from the sample 208.

In an embodiment the detector 240 is configured to detect signal particles by reference to the energy of the electron, i.e. dependent on a band gap. Such a detector 240 may be called an indirect current detector. The secondary electrons emitted from the sample 208 gain energy from the fields between the electrodes. The secondary electrodes have sufficient energy once they reach the detector 240.

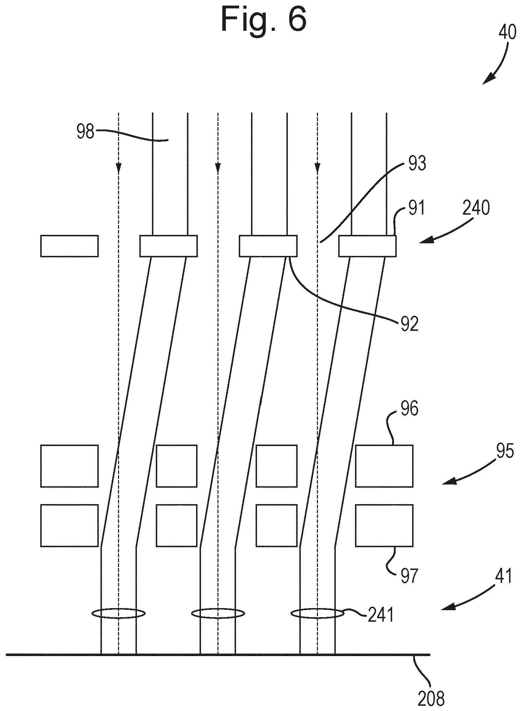

**FIG. 6** is a close-up view of part of the electron-optical apparatus 40 shown in **FIG. 5****.** In an embodiment the detector 240 comprises an electron to photon converter array 91. The electron to photon converter array 91 comprises a plurality of fluorescent strips 92. Each fluorescent strip 92 is located in the plane of the electron to photon converter array 91. At least one fluorescent strip 92 is arranged between two adjacent electron beams projected towards the sample 208.

In an embodiment, the fluorescent strips 92 extend substantially in the horizontal direction. Alternatively, the electron to photon converter array 91 may comprise a plate of a fluorescent material with openings 93 for the projected electron beams.

The projected electron beams, indicated by dashed lines in **FIG. 6****,** are projected through the plane of the electron to photon converter array 91, via the openings 93 between the fluorescent strips 92, towards the deflector array 95.

In an embodiment the deflector array 95 comprises a magnetic deflector 96 and an electrostatic deflector 97. The electrostatic deflector 97 is configured to counteract the deflection of the magnetic deflector 96 for the projected electron beams transmitted towards the sample 208. Accordingly, the projected electron beams may be shifted to a small extent in the horizontal plane. The beams down-beam of the deflector array 95 are substantially parallel to the beams up-beam of the deflector array 95.

In an embodiment the objective lens array 241 comprises a plurality of plates for guiding secondary electrons created in the sample 208 towards the deflector array 95. For the secondary electrons, which travel in opposite direction with respect to the projected electron beams, the electrostatic deflector 97 does not counteract the deflection of the magnetic deflector 96. Instead, the deflections of the secondary electrons by the electrostatic deflector 97 and the magnetic deflector 96 add up. Accordingly, the secondary electrons are deflected to travel at an angle with respect to the optical axis in order to transmit the secondary electrons onto the fluorescent strips 92 of the detector 240.

At the fluorescent strips 92, photons are created upon incidence of the secondary electrons. In an embodiment, the photons are transported from the fluorescent strip 92 to a photo detector (not shown) via a photon transport unit. In an embodiment, the photon transport unit comprises an array of optical fibers 98. Each optical fiber 98 comprises an end which is arranged adjacent or attached to one of the fluorescent strips 92 for coupling photons from the fluorescent strip 92 into the optical fiber 98, and another end which is arranged to project photons from the optical fiber 98 onto the photo detector.

The objective lens array 241 of any embodiment may comprise at least two electrodes in which are defined aperture arrays. In other words, the objective lens array comprises at least two electrodes with a plurality of holes or apertures. Adjacent electrodes of the objective lens array 241 are spaced apart from each other along the sub-beam paths. The distance between adjacent electrodes along the beam path, in which an insulating structure might be positioned as described below, is smaller than the size of an objective lens (along the beam path, i.e. between the most upbeam and most down beam electrode of the objective lens array). **FIG. 7** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the sub-beam paths 220. Thus, the electrodes are each provided with apertures through which the respective assessment sub-beam 211, 212, 213 propagates.

The aperture arrays 245, 246 of the objective lens array 241 may consist of a plurality of apertures, preferably with substantially uniform diameters, d. However there may be some variation for optimizing aberration correction as described in EP Application 20207178.3 filed on 12 November 2020 which is herein incorporated by reference at least with respect to corrections achieved by varying aperture diameter. The diameter, d, of the apertures in at least one electrode may be less than approximately 400 µm. Preferably, the diameter, d, of the apertures in at least one electrode is between approximately 30 to 300 µm. Smaller aperture diameters may provide larger detectors of the detector array 240 for a given aperture pitch, improving the chance of capturing backscatter signal particles. Thus the signal for the backscatter signal particles may improve. However, having apertures that are too small risk inducing aberrations in the primary sub-beams. The plurality of apertures in an electrode may be spaced apart from each other by a pitch, P. The pitch, P, is defined as the distance from the middle of one aperture to the middle of an adjacent aperture. The pitch between adjacent apertures in at least one electrode may be less than approximately 600 µm. Preferably, the pitch between adjacent apertures in at least one electrode is between approximately 50 µm and 500 µm. Preferably, the pitch between adjacent apertures on each electrode is substantially uniform. The values for the diameter and/or pitch described above can be provided in at least one electrode, multiple electrodes, or all electrodes in an objective lens array. Preferably, the dimensions referred to and described apply to all electrodes provided in an array of objective lenses.

The objective lens array 241 may comprise two electrodes, as shown in **FIG. 7****,** or three electrodes, or may have more electrodes (not shown). An objective lens array 241 having only two electrodes can have fewer aberrations, e.g. a lower aberration risk and/or impact, than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of two electrode lens over an Einzel lens is that the energy of an in-coming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the sub-beam paths. The distance between adjacent electrodes, in which an insulating structure might be positioned as described below, is larger than the objective lens. The objective lens array 241 can be configured to demagnify the charged particle beam by a factor greater than 10, desirably in the range of 50 to 100 or more. Each element in the objective lens array 240 may be a micro-lens operating a different sub-beam or group of sub-beams in the multi-beam.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the electron beam by a factor greater than 10, desirably in the range of 50 to 100 or more.

A detector 240 is provided to detect secondary and/or backscatter electrons emitted from the sample 208. The detector 240 is positioned between the objective lenses 234 and the sample 208. The detector 240 may otherwise be referred to as a detector array or a sensor array, and the terms "detector" and "sensor" are used interchangeably throughout the application.

In an embodiment the electron-optical device 41 is configured to project a beam of electrons towards the sample 208. The electron-optical device 41 may comprise the objective lens array 241. The electron-optical device 41 may comprise the detector 240. The array of objective lenses (i.e. the objective lens array 241) may correspond with the array of detectors (i.e. the detector 240) and/or any of the beams (i.e. the sub-beams).

An exemplary detector 240 is described below. However, any reference to the detector 240 could be a single detector (i.e. at least one detector) or multiple detectors as appropriate. The detector 240 may comprise detector elements 405 (e.g. sensor elements such as capture electrodes). The detector 240 may comprise any appropriate type of detector. For example, capture electrodes for example to detect directly electron charge, scintillators or PIN elements can be used. The detector 240 may be a direct current detector or an indirect current detector. The detector 240 may be a detector as described below in relation to **FIGs. 8-10****.**

The detector 240 may be positioned between the objective lens array 241 and the sample 208. The detector 240 is configured to be proximate the sample 208. The detector 240 may be very close to the sample 208. Alternatively, there may be a larger gap between, the detector 240 and the sample 208. The detector 240 may be positioned in the device so as to face the sample 208. Alternatively, the detector 240 may be positioned elsewhere in the electron-optical device 41 such that part of the electron-optical device that faces the sample 208 is other than, and thus is not, a detector. For example the detector 240 may have a part at least associated with an electrode of the objective lens array 241.

For a multi-beam system of the type shown in **FIGs. 2-5****,** preferably, a distance between the electron-optical column and the sample 208 is less than or equal to approximately 50 µm. The distance is determined as the distance from a surface of the sample 208 facing the electron-optical column and a surface of the electron-optical column facing the sample 208.

**FIG. 8** is a bottom view of the detector 240 which comprises a substrate 404 on which are provided a plurality of detector elements 405 each surrounding a beam aperture 406. The beam apertures 406 may be formed by etching through the substrate 404. In the arrangement shown in **FIG. 8****,** the beam apertures 406 are in a hexagonal close packed array. The beam apertures 406 can also be differently arranged, e.g. in a rectangular array. The beam arrangement of the hexagonal arrangement in **FIG. 8** may be more densely packed than a square beam arrangement. The detector elements 405 may be arranged in a rectangular array or a hexagonal array.

In an embodiment the beam apertures 406 have a pitch P of at least 50 µm, optionally at least 100 µm, optionally at least 200 µm and optionally 210 µm. A greater pitch allows for the diameter d of the beam apertures 406 to be greater. In an embodiment the beam apertures 406 have a pitch P of at most 1000 µm, optionally at most 500 µm, and optionally at most 250 µm. The pitch of the beam apertures 406 defines the pitch of the sub-beams of the electron multi-beam that is projected toward the sample 208. In an embodiment the sub-beams of the electron multi-beam have a pitch of at least 50 µm, optionally at least 100 µm, optionally at least 200 µm and optionally 210 µm. In an embodiment the beam apertures 406 have a diameter d that is less than the pitch P. In an embodiment the beam apertures 406 have a diameter d that is at least 10 µm, and optionally at least 20 µm. In an embodiment the beam apertures 406 have a diameter d that is at most 100 µm, optionally at most 50 µm, and optionally at most 30 µm. A smaller diameter d improves the resolution such that smaller defects can be detected.

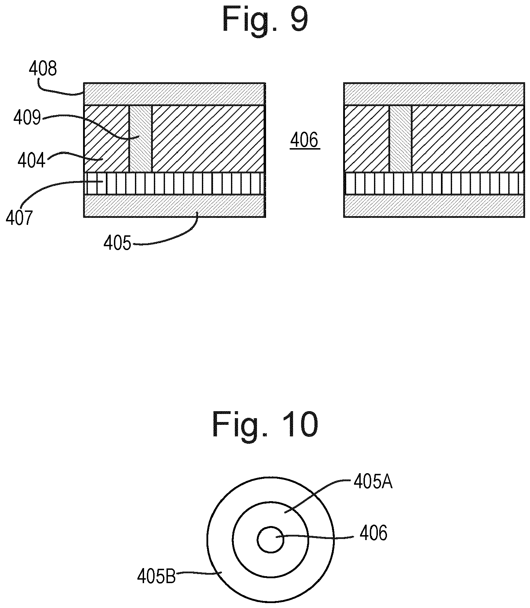

**FIG. 9** depicts at a larger scale a part of the detector 240 in cross section. The detector elements 405 form the bottommost, i.e. most close to the sample 208, surface of the detector 240. Between the detector elements 405 and the main body of the substrate 404 a logic layer 407 may be provided. At least part of the signal processing system may be incorporated into the logic layer 407.

A wiring layer 408 is provided on the backside of, or within, the substrate 404 and connected to the logic layer 407 by through-substrate vias 409. The number of through-substrate vias 409 need not be the same as the number of beam apertures 406. In particular if the electrode signals are digitized in the logic layer 407 only a small number of through-silicon vias may be required to provide a data bus. The wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector 240.

The integrated detector array described above is particularly advantageous when used with a tool having tunable landing energy as secondary electron capture can be optimized for a range of landing energies.

The detector 240 may be implemented by integrating a CMOS chip detector into a bottom electrode of the objective lens array 241. Integration of a detector 240 into the objective lens array 241 or other component of the electron-optical device 41 allows for the detection of electrons emitted in relation to multiple respective sub-beams. The CMOS chip is preferably orientated to face the sample (because of the small distance (e.g. 50 µm or less) between the sample and a bottom of the electron-optical column). In an embodiment, detector elements 405 to capture the secondary electrons are formed in the surface metal layer of the CMOS device. The detector elements 405 can be formed in other layers. Power and control signals of the CMOS may be connected to the CMOS by through-silicon vias. For robustness, preferably a passive silicon substrate with holes shields the CMOS chip from high E-fields.

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to the array pitch (i.e. the aperture array pitch described above in relation to the electrodes of the objective lens assembly 241). Therefore, the diameter of each detector element may be less than approximately 600 µm, and preferably between approximately 50 µm and 500 µm. As described above, the pitch may be selected depending on the intended distance between the sample 208 and the detector 240. In an embodiment the outer shape of the detector element 405 is a circle, but this can be made a square to maximize the detection area. Also the diameter of the through-substrate via 409 can be minimized. A typical size of the electron beam is in the order of 5 to 15 micron.

In an embodiment, a single detector element 405 surrounds each beam aperture 406. In another embodiment, a plurality of detector elements 405 are provided around each beam aperture 406. The electrons captured by the detector elements 405 surrounding one beam aperture 406 may be combined into a single signal or used to generate independent signals. The detector elements 405 may be divided radially. The detector elements 405 may form a plurality of concentric annuluses or rings. The detector elements 405 may be divided angularly. The detector elements 405 may form a plurality of sector-like pieces or segments. The segments may be of similar angular size and/or similar area. The electrode elements may be separated both radially and angularly or in any other convenient manner.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (annular) detector element 405 may provide a good compromise between collection efficiency and parasitic capacitance.

A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

The electron current collected by detector element 405 is amplified, for example by an amplifier such as a TIA.

In an embodiment, the objective lens array 241 is an exchangeable module, either on its own or in combination with other elements such as the control lens array 250 and/or the detector 240 and/or the beam shaping aperture array 262 and/or the sub-beam forming array 252. The exchangeable module may be field replaceable, i.e. the module can be swapped for a new module by a field engineer. In an embodiment, multiple exchangeable modules are contained within the tool and can be swapped between operable and non-operable positions without opening the electron-optical apparatus 40.

In an embodiment the exchangeable module comprises an electron-optical component, and specifically may be the electron-optical device, which is on a stage permitting actuation for positioning of the component. In an embodiment the exchangeable module comprises a stage. In an arrangement the stage and the exchangeable module may be an integral part of the tool 40. In an arrangement the exchangeable module is limited to the stage and the device, such as the electron-optical device, it supports. In an arrangement the stage is removable. In an alternative design the exchangeable module comprising the stage is removable. The part of the electron-optical apparatus 40 for the exchangeable module is isolatable, that is the part of the electron-optical apparatus 40 is defined by a valve up-beam and a valve down-beam of the exchangeable module. The valves can be operated to isolate the environment between the valves from the vacuum up-beam and down-beam of the valves respectively enabling the exchangeable module to be removed from the electron-optical apparatus 40 whilst maintaining the vacuum up-beam and down-beam of the part of the electron-optical apparatus 40 associated with the exchangeable module. In an embodiment the exchangeable module comprises a stage. The stage is configured to support a device, such as the electron-optical device, relative to the beam path. In an embodiment the module comprises one or more actuators. The actuators are associated with the stage. The actuators are configured to move the device relative to the beam path. Such actuation may be used to align the device and the beam path with respect to each other.

In an embodiment, the exchangeable module is a microelectromechanical systems (MEMS) module. MEMS are miniaturized mechanical and electromechanical elements that are made using microfabrication techniques. In an embodiment, the exchangeable module is configured to be replaceable within the electron-optical apparatus 40. In an embodiment, the exchangeable module is configured to be field replaceable. Field replaceable is intended to mean that the module may be removed and replaced with the same or different module while maintaining the vacuum in which the electron-optical tool 40 is located. Only a section of the electron-optical apparatus 40 is vented corresponding to the module is vented for the module to be removed and returned or replaced.

The control lens array 250 may be in the same module as an objective lens array 241, i.e. forming an objective lens array assembly or objective lens arrangement, or it may be in a separate module

In some embodiments, one or more aberration correctors are provided that reduce one or more aberrations in the sub-beams. The one or more aberration correctors may be provided in any of the embodiments, e.g. as part of the electron-optical device, and/or as part of an optical lens array assembly, and/or as part of an assessment system. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, the objective lens array 241. In an embodiment, these aberration correctors reduce one or more of the following: field curvature; focus error; and astigmatism. Additionally or alternatively, one or more scanning deflectors (not shown) may be integrated with, or directly adjacent to, the objective lens array 241 for scanning the assessment sub-beams 211, 212, 213 over the sample 208. In an embodiment, the scanning deflectors described in US 2010/0276606, which document is hereby incorporated by reference in its entirety, may be used.

The detector may be provided with multiple portions and more specifically, multiple detecting portions. The detector comprising multiple portions may be associated with one of the assessment sub-beams 211, 212, 213. Thus, the multiple portions of one detector 240 may be configured to detect signal particles emitted from the sample 208 in relation to one of the primary beams (which may otherwise be referred to as assessment sub-beams 211, 212, 213). In other words, the detector comprising multiple portions may be associated with one of the apertures in at least one of the electrodes of the objective lens assembly. More specifically, the detector 405 comprising multiple portions may be arranged around a single aperture 406 as shown in **FIG 10****,** which provides an example of such a detector.

As shown in **FIG. 10****,** the detector element 405, in which an aperture 406 is defined and configured for the through passage of an electron beam, comprises an inner detecting portion 405A and an outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings.

The invention can be applied to various different tool architectures. For example, the electron-optical apparatus 40 may comprise a plurality of electron-optical columns of multi-beams. The electron-optical columns may comprise the electron-optical device 41 described in any of the above embodiments or aspects. As a plurality of electron-optical columns (or a multi-column tool), the devices may be arranged in an array which may number two to one hundred electron-optical columns or more. The electron-optical apparatus 40 may take the form of an embodiment as described with respect to and depicted in **FIG. 4** or as described with respect to and depicted in **FIG. 5****.** An electron-optical column may optionally comprise a source.

As mentioned above, to increase contrast for electron beam inspection the surface of the sample 208 can be illuminated with light prior to the inspection of the sample 208. This process may be called advanced charge control. Such illumination may excite electrons within the sample 208. Such excited electrons within a sample 208 are more likely to interact with impinging electrons from incidental primary sub-beams of the multi-beam. Consequently, such illumination may be used to improve the strength of the signal particle signal. The optical illumination may improve contrast of the detected signal.

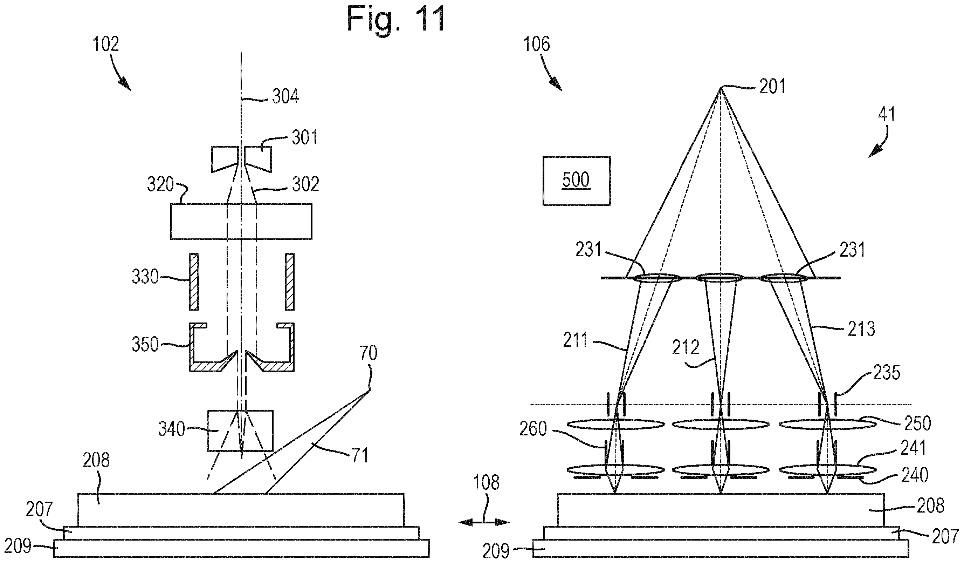

**FIG. 11** depicts an electron-optical apparatus for assessing a sample 208 using charged particles (e.g., electrons). The apparatus comprises a preparatory electron-optical device 102, an assessment electron-optical device 106 and a control system 500. The assessment electron-optical device 106 may comprise the electron-optical device 41 described elsewhere in this document, for example as described with reference to **FIGs. 2-6****.** The control system 500 controls the apparatus to perform various functions as described below. The control system 500 may comprise or consist of a controller 50 taking any of the forms described above with reference to **FIG. 1****.** The control system 500 may comprise a single unit configured to perform all of the control functionality or may comprise a distributed system of units that together allow the required functionalities to be achieved. The control system 500 may be at least partially computer implemented. Any suitable combination of elements (e.g., CPUs, RAM, data storage, data connections, sensors, etc.) may be provided and suitably programmed to achieve some or even all the specified functionality. Any reference herein to an apparatus, device or system being configured to perform functionality is intended to encompass the case where the control system 500 is configured to cause the functionality to be performed (e.g., by being suitably programmed to provide control signals that cause the functionality to happen).

In an embodiment, the exposing of the target area comprises a flood exposure. The preparatory electron-optical device 102 may comprise a flood column configured to provide the flood exposure. **FIG. 11** depicts an example configuration for a flood column in a preparatory electron-optical device 102, although other electron-optical designs of flood column may be used. In this example, the flood column comprises a charged particle source 301, a condenser lens 320, a blanker electrode 330, an objective lens 340 and an aperture body 350. The flood column may also comprise additional components for manipulation of the preparatory charged particle beam 302 such as a scanning element (not shown) and a field lens (not shown). The components of the flood column may be arranged substantially along an axis 304.

The charged particle source 301 may be an electron source. The charged particle source 301 may comprise a charged particle emitting electrode (e.g. a cathode) and an accelerating electrode (e.g. an anode). The charged particles are extracted or accelerated from the charged particle emitting electrode by the accelerating electrode to form a preparatory charged particle beam 302. The preparatory charged particle beam 302 may propagate along a preparatory beam path 302. The preparatory beam path 302 may comprise the axis 304, for example in situations in which the preparatory charged particle beam 302 is not deflected away from the axis 304.

The condenser lens 320 is positioned down-beam of the charged particle source 301, i.e. the condenser lens 320 is positioned in a down-beam direction relative to the charged particle source 301. The condenser lens 320 may focus or defocus the preparatory charged particle beam 302. As shown in **FIG. 11****,** the condenser lens 320 may be used to collimate the preparatory charged particle beam 302. However, the condenser lens 320 may also be used to control the preparatory charged particle beam 302 to create a divergent beam or a convergent beam.

The aperture body 350 may be positioned down-beam of the condenser lens 320. The aperture body 350 may pass a portion, or only a portion and not all, of a charged particle beam propagating along an axis 304. The aperture body 350 may limit the lateral extent of the preparatory charged particle beam 302, as depicted in **FIG. 11****.** The aperture body 350 may also be used to selectively blank the preparatory charged particle beam 302, so as to prevent passage of any portion of the preparatory charged particle beam 302. The aperture body 350 may define an opening. If the lateral extent (or diameter) of the preparatory charged particle beam 302 is larger than the lateral extent (or diameter) of the opening, then only a portion of the preparatory charged particle beam 302 will pass through the opening. The aperture body 350 may thus limit the lateral extent of the preparatory charged particle beam 302, so as to act as a beam-limiting aperture.

The blanking electrode 330 may be positioned down-beam of the condenser lens 320 and up-beam of the aperture body 350. The blanking electrode 330 may selectively deflect the preparatory charged particle beam 302, for example deflect the preparatory charged particle beam 302 away from the axis 304. The blanking electrode 330 may deflect the preparatory charged particle beam 302 away from the opening in the aperture body 350, for example onto a portion of the aperture body 350 that does not comprise the opening, so as to prevent any portion of the preparatory charged particle beam 302 from passing through the opening defined by the aperture body 350. The blanking electrode 330 may blank the beam so that beam does not pass through the opening of the aperture body 350. However, the combination of the blanking electrode 330 and the aperture body 350 may also be used to selectively blank the preparatory charged particle beam 302, i.e. to selectively prevent passage of at least part the preparatory charged particle beam 302 through the opening in the aperture body 350. That is, the combination of the blanking electrode 330 and the aperture body 350 may selectively control the proportion of the preparatory charged particle beam 302 that passes the opening.

The objective lens 340 is positioned down-beam of the aperture body 350. The objective lens 340 may focus or defocus the preparatory charged particle beam 302. As shown in **FIG. 11****,** the objective lens 320 may be used to control the preparatory charged particle beam 302 so as to create a divergent beam, thereby increasing the spot size on the sample 208 and increasing the area of the surface on the sample 208 that is flooded with charged particles. A more divergent beam may generate a beam spot on the sample with a larger field of view. However, in some situations, the objective lens 340 may be used to control the preparatory charged particle 302 so as to create a convergent beam, thereby focusing the preparatory charged particle beam 302 onto the sample 208. A more convergent beam may generate a beam spot on the sample with a smaller field of view.

In an embodiment, the assessment electron-optical device 106 exposes the sample 208 with a multi-beam of charged particles, the multi-beam comprising a plurality of individual beams of charged particles. The example of **FIG. 11** shows a multi-beam comprising three individual beams but in practice the multi-beam may comprise many tens, hundreds or thousands of beams.

In an embodiment, the assessment electron-optical device 106 comprises a electron-optical device 41. The electron-optical device 41 may take any of the forms described above with reference to **FIG. 3** and **7** for example, such as with an array of electron-optical elements proximate the sample 208, such as an objective lens array 241 or detector array 240. In an embodiment the assessment electron-optical device 106 comprises an objective lens comprises a plurality of objective lenses for different beams of the assessment charged particle beam. In the particular example of **FIG. 11** the assessment electron-optical device 106 corresponds to the arrangement of **FIG. 3** and may operate and/or take any of the forms described above with reference to **FIG. 3****.** The electron-optical device 41 is used during the assessing of the sample 208 to direct the charged particles onto the sample 208 and to detect the signal charged particles from the sample 208.

In an embodiment electron-optical apparatus is for assessing a sample at an assessment location. In **FIG. 11****,** the assessment location is below the assessment electron-optical device 106. As shown in **FIG. 11****,** in an embodiment the electron-optical apparatus comprises an assessment charged particle-optical device 106, a preparatory charged particle-optical device 102 and a light source 70. The assessment charged particle-optical device 106 is configured to project an assessment charged particle beam 211-213 along an assessment beam path toward an assessment location. The assessment charged particle beam is for assessing a sample 208 at the assessment location. The preparatory charged particle-optical device 106 is configured to project a preparatory charged particle beam along a preparatory beam path. The preparatory charged particle beam is for preparing a sample for assessment.

As shown in **FIG. 11****,** in an embodiment the electron-optical apparatus 40 comprises a light source 70. The light source 70 may be a module, or part of a module, and may be referred to as a module configured to generate a light beam for photo-stimulation of the illuminated surface. Such a light source may be comprised in an 'advanced charge control module, e.g. an ACC module. The light source 70 is arranged to project (or direct) a light beam 71 toward the sample 208. In an embodiment the light source 70 is configured to project a light beam 71 toward an illumination location. The light source 70 may be part of a projection system for illuminating the sample before assessment of at least a sample portion of the sample.

When an electron beam scans the sample 208, charges may be accumulated on the sample 208 due to large beam current, which may affect the quality of the image. The light source 70 may illuminate the light beam 71 on the sample 208, so as to control the accumulated charges due to effects such as photoconductivity, photoelectric, or thermal effects.

In an embodiment the light source 70 is a laser light source. Laser light provides a coherent light beam 71. However, other types of light source can alternatively be used. In an embodiment the light source 70 is configured to emit a light beam 71 having a wavelength in the range of from 450nm to 850nm, preferably from 450nm to 800nm. The selected wavelength may correspond to a wavelength absorbed by the material of the sample 208. The selected wavelength may tend to excite electrons in the sample 208 on incidence of the light with the sample 208. In an embodiment the light source 70 is part of a projection assembly that comprises an optical system. In an embodiment the optical system is configured to focus the light beam 71.

By illuminating the sample 208 with the light beam 71 the defect contrast is significantly improved. This technique, which may be referred to as voltage contrast, may be used to measure whether there is a proper electrical connection between a contact and the substrate of the sample 208. Depending on the secondary electron yield (<1 or >1) the contact to the N+ or P+ doped region on the substrate forms a diode in reverse. As a result, it can be the case that it is not possible to distinguish between a proper and a bad electrical connection for either the N+ or the P+ contacts. By illuminating the sample 208 with a light beam 71 (ACC) the diode in reverse is made conductive. As a result, the contact will not charge in case there is a proper electrical connection between contact and substrate, but it will charge in case the electrical connection is bad.

The assessment electron-optical device 106 may have a field of view. The field of view may be the area on the surface of the sample 208 on which electrons projected by the assessment electron-optical device 106 may be incident. The field of view may 1mm, for example 5mm, for example 10mm or even 20mm. The assessment electron-optical device 106 may have a large field of view. Since the electron-optical device is comprised in a substrate of for example silicon, the plate forming the most down beam surface of the device may be larger than the beam grid in surface area. A working distance between the assessment electron-optical device 106 and the sample 208 may be restricted (e.g. have a maximum value for example in the range of 10 to 100 micron as described previously), for example for electron-optical reasons as disclosed herein in relation to **FIGs. 2 to 5****.** These dimensions may create a gap that is limited or small (e.g. narrow) in height (or along the direction of the beam path) and wide (for example in a direction across or even orthogonal to the beam path). The gap may be considered to be narrow and also wide. The dimensions of the gap make it difficult to illuminate the sample for photo-stimulation of the sample (or use ACC). For example the trajectory of a light beam, e.g. of an ACC, to reach the inspection region (i.e. the area of the surface of the sample 208 to be assessed) would be larger than the glancing angle preventing the sample 208 from absorbing the light.

In an embodiment a locational relationship between the illumination location and the assessment charged particle-optical device 106 is different from a locational relationship between the assessment location and the assessment charged particle-optical device 106. For example, in an embodiment the assessment location is different from the illumination location. The sample 208 may be illuminated by the light beam 71 in a different location from where it is assessed. Alternatively, the sample 208 may remain stationary between illumination and assessment and the electron-optical devices 102, 106 may be moved such that the relative position between the sample 208 and the electron-optical device 102, 106 changes between illumination and assessment.

An embodiment of the invention is expected to achieve photonic stimulation (e,g. ACC with an electron-optical architecture of an assessment electron-optical device 106 in which the bottom of the device has a small displacement from the sample 208 and may have a large field of view.

In an embodiment a field of view of the assessment charged particle-optical device 106 at the assessment location is wider in a direction across the assessment beam path than a distance between the assessment location and the assessment charged particle-optical device 106 in a direction along the assessment beam path.

In an embodiment a preparatory portion is the surface of the sample prepared by the preparatory beam and an assessment portion is the surface of the sample assessed by the assessment beam at the assessment location, wherein the preparatory portion is as least as large as the assessment portion.

In an embodiment the preparatory portion corresponds to the field of view of the preparatory beam and the assessment portion corresponds to the field of view of the assessment beam at the assessment location.

In an embodiment the contacts with a bad electrical connection to the substrate prior to the assessment are charged by means of the preparatory electron-optical device 102. In order to make sure both the N+ and P+ contacts with proper electrical connection do not charge, the sample 208 may be illuminated by the light source 70 prior to the assessment. This can be done during the projection of the preparatory beam (e.g. flooding), or after the projection of the preparatory beam. Because the light beam illumination is done prior to the assessment a small gap between the assessment electron-optical device 106 and the sample 208 is less of a problem. The light source 70 may be part of the preparatory electron-optical device 102, and not part of the assessment electron-optical device 106.

By controlling the landing energy of the electrons of the preparatory electron beam, the contacts with bad electrical connection can be charged positively or negatively. During the assessment the contacts with bad electrical connection will charge further, and in addition the contacts with a proper electrical connection but connected to a diode in reverse will also charge further. In an embodiment the charging during projection of the preparatory electron beam and during projection of the assessment electron beam are in the same direction, for example by projecting the preparatory electron beam with the same landing energy as the landing energy of the assessment electron beam.

During projection of the preparatory electron beam (e.g. during flooding), defective contacts are charged, "diode in reverse" contacts are charged and "diode in conduction" contacts remain discharged. During projection of the light beam 71, defective contacts remain charged, "diode in reverse" contacts are discharged and "diode in conduction" contacts remain discharged. During projection of the assessment electron beam defective contacts are charged further, "diode in reverse" contacts are charged and "diode in conduction" contacts remain discharged. It may be possible to distinguish between the defective contacts that are charged further and the "diode in reverse" contacts that are merely charged. By performing the projection of the preparatory electron beam and the projection of the light beam, it is easier to distinguish between good contacts and bad contacts. It may not be necessary to project the light beam simultaneously with projection of the assessment electron beam.

If for a specific voltage contrast application use of photonic stimulation, e.g. ACC, is mandatory, an embodiment of the invention is expected to increase throughput, for example by allowing use of photonic stimulation (e.g. ACC) in the context of an apparatus with a large field of view and a small gap to the sample 208.

In an embodiment of the invention, the preparatory electron-optical device 102 projects a preparatory beam onto the sample 208 before assessment to charge the contacts in the sample 208 that have a bad electrical connection to the sample 208 (which may be referred to as bad contacts). During or shortly after flooding, such as between a preparatory location where the preparatory electron-optical device 102 projects a preparatory beam onto (e.g. floods) the sample 208 and an assessment location where the assessment electron-optical device 106 is used to assess a sample 208, the sample 208 may be illuminated with a light beam 71 suitable for ACC. This may help to ensure that contacts with sound electrical connection (which may be referred to as good contacts) do not charge.

In an embodiment the light source 70 projects the light beam 71 either in the preparatory electron-optical device 102 or positioned along a path of the sample 208 between the preparatory location and the assessment location. During the assessment (e.g. inspection) the bad contacts charge further with the charge from the assessment electron beam of the assessment electron-optical device 106, as do good contacts connected as a reverse diode.

In an embodiment the light source 70 is configured to project a light beam 71 toward the sample at an illumination location away from the assessment location. The dimensions of the assessment electron-optical device 106 relative to the sample 208 do not prevent use of the light beam 71.

In an embodiment the light source 70 is configured to project the light beam toward the illumination location before the assessment charged particle-optical device 106 projects the assessment charged particle beam toward the assessment location for assessing a sample 208 at the assessment location.

In an embodiment the preparatory charged particle-optical device 102 is configured to project the preparatory charged particle beam 302 while the light source 70 projects the light beam 71 toward the illumination location. The projection of the preparatory electron beam and the projection of the light beam 71 may be performed in parallel. Alternatively one may be done after the other or their time periods may partially overlap each other.

In an embodiment the preparatory charged particle-optical device 102 is configured to project the preparatory charged particle beam toward the illumination location. In an embodiment the light source 70 is configured to project the light beam 71 toward the illumination location after the preparatory charged particle-optical device 102 projects the preparatory charged particle beam.

In an embodiment the illumination location is displaced away from the assessment beam path. In an embodiment the preparatory charged particle-optical device 102 is configured to project the preparatory charged particle beam along the preparatory beam path toward a preparatory location. The preparatory location may be the same or different from the illumination location.

In an embodiment the illumination location is between the preparatory location and the assessment location. In an embodiment a distance between the illumination location and the preparatory location is less that a distance between the illumination location the assessment location. In an embodiment a distance between the illumination location and the assessment charged particle-optical device 106 is greater than a distance between the assessment location and the assessment charged particle-optical device 106. In an embodiment a distance between the assessment location and the assessment charged particle-optical device 106 in a direction along the assessment beam path is less than a distance between the illumination location and the preparatory charged particle-optical device 102 in the direction along the assessment beam path. In an embodiment a distance between the assessment location and the assessment charged particle-optical device 106 in a direction along the assessment beam path is less than a distance between the assessment location and the preparatory charged particle-optical device 102 in the direction along the assessment beam path. In an embodiment a distance between the assessment location and the assessment charged particle-optical device 106 is less than a distance between the illumination location and the assessment charged particle-optical device 106 in the direction along the assessment beam path location.

In an embodiment the assessment location is in a sample plane and the illumination location is in the sample plane. Alternatively they may be in different planes. In an embodiment the illumination location is displaced further than the assessment location in a direction along the assessment beam path.

In an embodiment the light source 70 is associated with the preparatory charged particle-optical device 102. In an embodiment the light source 70 is integrated with the preparatory charged particle-optical device 102. In an embodiment at least part of a light beam path along which the light source is configured to project the light beam is parallel to a direction of the preparatory beam path. In an embodiment at least part of a light beam path along which the light source is configured to project the light beam is along at least part of the preparatory beam path.

Alternatively, in an embodiment the light source is associated with the assessment charged particle-optical device. In an embodiment the light source is configured to project the light beam when the sample is proximate to the assessment location. For example, the illumination location is along the path of the stage movement, for example the sample movement, from the preparatory location to the assessment location, such as proximate to the assessment location (or assessment position). The illumination location may be as the sample moves within a footprint to the assessment charged particle device 106, such as into the path of the assessment beam for example as a beam grid.

In an embodiment, the illumination location is further down the assessment beam path from the assessment location. In such an arrangement, distance between the assessment charged particle device and the sample may be greater than during assessment. A lower stage for illumination than assessment may ensure illumination of the sample is more efficient. The actuatable stage 209 may be moved to and/or from the preparatory location, such as from the assessment location, when the actuatable stage 209 is lowered such as described in WO 2022128392 A1 which disclosure is hereby incorporated by reference. In a different embodiment, the actuatable stage 209 may be moved in a direction along the assessment beam path, e.g. lowered, at a location between a the assessment location and the preparatory location.

In an embodiment, the actuatable stage 209 comprises independently actuatable long-stroke and short-stroke stages. A maximum range of motion of the long-stroke stage is longer than a maximum range of motion of the short-stroke stage. In an embodiment, the short-stroke stage is supported by the long-stroke stage. Movement of the long-stroke stage may causes a corresponding movement of the short-stroke stage without any actuation of the short-stroke stage. The long-stroke stage may be configured to provide relatively coarse position control over relatively long distances (i.e. for long moves). The short-stroke stage may be configured to provide finer position control over shorter distances. In an embodiment the range of motion provided by a short stroke stage may be 1 mm or less, i.e. a displacement 0.5 mm or less in magnitude with respect to the position of the long-stroke stage. The actuation of the long stroke may be used to achieve the movement of the sample 208 in a direction along the assessment beam path for example when moving from the assessment location to the preparatory location. Actuation of the long stroke may be used to raise the sample 208 when actuating the sample 208 back to the assessment location.

Having the illumination position at a plane further from the assessment charged particle device along the assessment beam path may be desirable during a long move of the stage (e.g. by the long-stroke stage) for example between the preparatory location to within the footprint of the assessment charged particle device so that the gap between the assessment charged particle device and the sample is larger than between the assessment charged particle device and the sample during assessment, Such a larger gap during a long move helps undesirable collisions between the stage and/or sample with the assessment charged particle device. The illumination position may be desirably positioned along the long move between the preparatory position and the assessment position.

As a further alternative, in an embodiment the light source is comprised in an illumination device between the assessment charged particle device and the preparatory charged particle device. In an embodiment the illumination device is separate from the assessment charged particle-optical device and the preparatory charged particle-optical device.

In an embodiment the preparatory charged particle-optical device 102 is a flooding charged particle-optical device for flooding a surface of a sample with charged particles.

In an embodiment the assessment charged particle-optical device and/or the preparatory charged particle-optical device comprises one or more charged particle-optical elements which comprise a microelectromechanical component (MEMS component). In an embodiment the assessment charged particle beam is a beam grid of a plurality of beams.

In an embodiment a surface of the assessment charged particle-optical device 106 that is configured to face the assessment location is an array of detectors.

In an embodiment the charged particle-optical apparatus comprises a controller configured to control one or more of the assessment charged particle-optical device, the preparatory charged particle-optical device and the light source.

In an embodiment a charged particle-optical apparatus comprises an actuatable stage 209 configured to support a sample 208. In an embodiment the actuatable stage 209 is configured to move the sample from the illumination location to the assessment location. In **FIG. 11****,** the movement of the actuatable stage 209 between the illumination location and the assessment location is indicated by the double ended arrow 108. In an embodiment the actuatable stage 209 is configured to move the sample from the illumination location to the assessment location after the light source has projected the light beam toward the illumination location. In an embodiment the actuatable stage is configured to move the sample into the assessment location before the assessment charged particle-optical device is configured to project the assessment charged particle beam toward the assessment location. In an embodiment the actuatable stage is configured to move the sample to the illumination location before the assessment charged particle-optical device is configured to project the assessment charged particle beam toward the assessment location.

In an embodiment, the electron-optical apparatus 40 comprises a plurality of electron-optical devices as depicted in the figures, for example at least **FIG. 3** and **FIG. 4****,** subject to the following comments, as a multi-column apparatus. Such a multi-column apparatus may comprise a plurality of electron-optical columns arranged in an array such as in a rectangular or hexagonal pattern. Each column of the multi-column apparatus may feature the features and functionality of the arrangement depicted in and disclosure in reference to **FIG. 3** herein. Alternatively, the multi-column apparatus may comprise a plurality of columns that are arranged in an array for example having a regular pattern and that comprise the features and functionality of the electron-optical device 41 depicted in and described with reference to **FIG. 4** subject to the following differences. Such differences include having an array of collimators, such as collimating deflectors for example integrated into the objective lens array assembly for example associated with, preferably immediately down beam of, an aperture of the sub-beam forming array 252. Each collimating deflector is assigned to a respective sub-beam of the multi-beam. The differences may comprise an array of scan deflectors integrated into the objective lens array assembly for example associated with the objective lens array 241. Having a scan deflector array and collimator array is beneficial because such devices are electrostatic instead of magnetic. Electron-optical column architectures having magnetic devices are difficult to integrate into a multi-column arrangement because of the interference of the magnetic device with the surrounding columns of the multi-column arrangement.

In an embodiment there is provided a method for assessing a sample 208. In an embodiment the method comprises projecting with a preparatory charged particle-optical device a preparatory charged particle beam along a preparatory beam path, the preparatory charged particle beam for preparing a sample for assessment. In an embodiment the method comprises projecting a light beam toward the sample at an illumination location. In an embodiment the method comprises projecting with an assessment charged particle-optical device an assessment charged particle beam along an assessment beam path toward the sample at an assessment location, the assessment charged particle beam for assessing the sample at the assessment location. In an embodiment a locational relationship between the illumination location and the assessment charged particle-optical device is different from a locational relationship between the assessment location and the assessment charged particle-optical device.

In an embodiment there is provided a method for assessing a sample 208. In an embodiment the method comprises projecting with a preparatory charged particle-optical device a preparatory charged particle beam along a preparatory beam path, the preparatory charged particle beam for preparing a sample for assessment. In an embodiment the method comprises projecting a light beam toward the sample at an illumination location. In an embodiment the method comprises projecting with an assessment charged particle-optical device an assessment charged particle beam along an assessment beam path toward the sample at an assessment location, the assessment charged particle beam for assessing the sample at the assessment location. In an embodiment the light beam is projected toward the sample at the illumination location when the sample is away from the assessment location.

In an embodiment the light beam is projected toward the illumination location before the assessment charged particle-optical device projects the assessment charge particle beam toward the assessment location. In an embodiment the preparatory charged particle-optical device projects the preparatory charged particle beam toward the sample while the light beam is projected toward the illumination location. In an embodiment the light beam is started to be projected toward the sample with the start of the projection of the preparatory charged particle beam toward the sample.

In an embodiment the light beam is projected toward the sample after the projection of the preparatory beam towards the sample has stopped. In an embodiment the light beam is started to be projected toward the sample after the start of the projection of the preparatory charged particle beam towards the sample.

As shown in **FIG. 11****,** in an embodiment the light source 70 is configured to project the light beam 71 toward the sample 208 in the gap between the flood column of the preparatory electron-optical device 102 and the sample 208. In an embodiment the method comprises moving with an actuatable stage the sample from the illumination location to the assessment location after the light beam has been projected toward the sample.

It is not essential for the light beam 71 to be projected through the gap between the flood column and the sample 208. Additionally or alternatively, the light beam 71 may be projected down the flood column. The light beam may be directed along the electron-optical axis 304, for example through the electron-optical components of the flood column (e.g. through one or more of the charged particle source 301, condenser lens 320, blanker electrode 330, objective lens 340 and aperture body 350), for example along or adjacent to the path of the preparatory charged particle beam through the flood column. The light source 70 may be located near the charged particle source 301. In an embodiment, the light beam 71 may be projected from a position, for example the light source 70, positioned along the path of the preparatory charged particle beam between the charged particle source 301 of the flood column and the sample, for example from a component of the flood column along the path of the charged particle beam. Such a component may be the condenser lens 320, blanker electrode 330, objective lens 340 and aperture body 350.

Additionally or alternatively, the light beam 71 may be projected toward the sample 208 at a location between the flood column and the preparatory electron-optical device 106. **FIG. 12** is a schematic view of such an electron-optical apparatus. **FIG. 12** shows the actuatable stage 209 at an intermediate position between the preparatory electron-optical device 102 and the assessment electron-optical device 106. The intermediate position may be between the assessment location and the preparatory location. In the intermediate position, the actuatable stage 209, or even the sample 208 may be partly under the footprint of the flood column or the footprint of the electron-optical device 41 of the electron-optical apparatus 40. In such an intermediate position, the light beam 71 may be angled to illuminate at least a portion of the sample The light source 70 may be located between the preparatory electron-optical device 102 and the assessment electron-optical device 106. In an embodiment the light source 70 is configured to project the light beam 71 toward the sample 208 during movement of the sample 208. It may not be necessary to stop the sample 208 while the light beam 71 is projected toward it. The light beam may scan at least a portion of the sample. Alternatively, the actuatable stage 209 may be configured to stop the sample 208 at the intermediate location while the light source 70 projects the light beam 71 toward the sample 208.

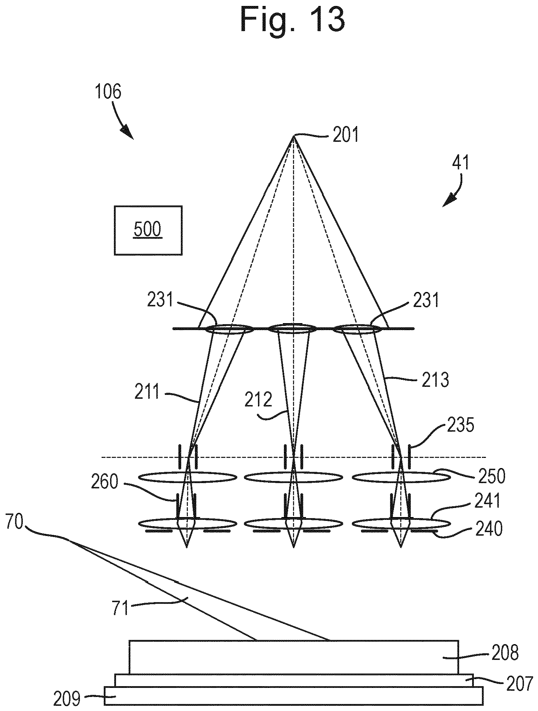

**FIG. 13** is a schematic view of an assessment electron-optical apparatus 106. As shown in **FIG. 13****,** in an embodiment the light beam 71 is projected toward the sample 208 before the actuatable stage 209 is raised after moving back under the assessment electron-optical apparatus 106. The light beam 71 is provided before an assessment process. The light source 70 may be positioned adjacent the electron-optical device 41. In an embodiment the illumination location is in a different plane along a direction of the assessment beam path from the assessment location, wherein desirably the sample is moved between the different planes of the illumination location and the assessment location when moving the sample between the assessment location and the illumination location. In an embodiment the actuatable stage 209 is configured to move the sample 208 within a plane from under the preparatory electron-optical apparatus 102 (e.g. from the preparation location) to under the assessment electron-optical apparatus 106 (e.g. to the assessment location). The plane is different from (e.g. lower than) the plane of the assessment location. The sample may be moved between the preparation location and the assessment location for example at a plane further down the assessment beam path. The light source 70 is configured to project the light beam 71 toward the sample 208 while the sample 208 is at the lower plane. This allows space for the light beam 71 to reach the sample 208. The actuatable stage 209 is configured to subsequently move the sample 208 between the planes to the assessment location where the sample 208 may be assessed (e.g. inspected).

The path of the light beam 71 may be angled relative the orthogonal of a surface of the sample 208 and/or the direction of the assessment beam path. A position of the sample 208 may be illuminated by the light beam 71 when and/or as the sample 208 moves into, for example under, the footprint of the changed particle device 41; for example before the sample 208 is actuated up towards the assessment position for example in a plane further up the assessment beam path. Alternatively, if the gap between the sample 208 and the facing surface of the electron-optical device 41 is large enough, the at least a portion of the sample 208 is illuminated by the light beam as the sample 208 is actuated along the assessment beam path to the assessment location. In an embodiment, the light beam path may be orthogonal to a surface of the sample 208 and/or in a direction co-parallel to the assessment beam path. The light beam 71 may be incident on the sample 208, for example at the intermediate position, as the sample 208 is moved towards the assessment location, for example before the sample 208 is moved along the beam path towards the sample position. The intermediate position may be adjacent the electron-optical device 41, for example incorporated into the electron-optical device 41. The light source 70 may be adjacent, or even incorporated into e.g. integrated into, the electron-optical device 41, such as support features of the electron-optical device 41. In an embodiment, the at least a portion of the sample 208 illuminated by the light beam 71 is in, for example under, the footprint of the electron-optical device 41.

In an embodiment there is provided a method for assessing a sample 208. In an embodiment the method comprises projecting a preparatory charged particle beam toward a sample for preparing the sample for assessment. In an embodiment the method comprises projecting a light beam toward the sample. In an embodiment the method comprises projecting an assessment charged particle beam along an assessment beam path toward the sample at an assessment location for assessing the sample at the assessment location. In an embodiment the projecting of the light beam is before the sample is at the assessment location.

Although the invention has been described primarily herein for an assessment charged particle device 106 as depicted in and described with reference to any of **FIGs. 3 to 5****,** the invention can be applied to a charged particle system having a single beam device or a multibeam device with a common, single magnetic objective lens, as the assessment charged particle device. Such a multibeam device may have a magnetic condenser lens, an array of one or more electron-optical elements for example between the condenser lens and the objective lens and a secondary column comprising a detector array for detecting a plurality of beams of charged particles from a sample. A Wien filter above the objective lens may separate charged particles from the sample in response to the multiple beam from the multibeam of charged particles directed towards the sample.

In an embodiment the method is for assessing the sample 208 performing a voltage contrast measurement (i.e. by an assessment process). Suitable apparatus and associated method for such illumination of a sample and/or for such a voltage contrast measurement is herein disclosed and described.

Reference to a component or system of components or elements being controllable to manipulate an electron beam in a certain manner includes configuring a controller or control system or control unit to control the component to manipulate the electron beam in the manner described, as well optionally using other controllers or devices (e.g. voltage supplies and or current supplies) to control the component to manipulate the electron beam in this manner. For example, a voltage supply may be electrically connected to one or more components to apply potentials to the components, such as in a non-limited list the control lens array 250, the objective lens array 241, the condenser lenses 231, correctors, a collimator element array and scan deflector array, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a sub-beam forming array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques).

References to upper and lower, up and down, above and below should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

An electron-optical apparatus according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column may be a component of an assessment system; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

The descriptions above are intended to be illustrative, not limiting. Thus, it will be apparent to one skilled in the art that modifications may be made as described without departing from the scope of the claims and clauses set out below.

There are the following clauses:
Clause 1. A charged particle-optical apparatus for assessing a sample at an assessment location, the charged particle-optical apparatus comprising: an assessment charged particle-optical device configured to project an assessment charged particle beam along an assessment beam path toward an assessment location, the assessment charged particle beam for assessing a sample at the assessment location; a preparatory charged particle-optical device configured to project a preparatory charged particle beam along a preparatory beam path, the preparatory charged particle beam for preparing a sample for assessment; and a light source configured to project a light beam toward an illumination location; wherein a locational relationship between the illumination location and the assessment charged particle-optical device is different from a locational relationship between the assessment location and the assessment charged particle-optical device.
Clause 2. A charged particle-optical apparatus for assessing a sample at an assessment location, the charged particle-optical apparatus comprising: an assessment charged particle-optical device configured to project an assessment charged particle beam along an assessment beam path toward an assessment location, the assessment charged particle beam for assessing a sample at the assessment location; a preparatory charged particle-optical device configured to project a preparatory charged particle beam along a preparatory beam path, the preparatory beam for preparing a sample for assessment; and a light source configured to project a light beam toward the sample at an illumination location away from the assessment location.
Clause 3. The charged particle-optical apparatus of clause 1 or 2, wherein the light source is configured to project the light beam toward the illumination location before the assessment charged particle-optical device projects the assessment charged particle beam toward the assessment location for assessing a sample at the assessment location.
Clause 4. The charged particle-optical apparatus of clause 1, 2 or 3, wherein the preparatory charged particle-optical device is configured to project the preparatory charged particle beam while the light source projects the light beam toward the illumination location.
Clause 5. The charged particle-optical apparatus of any preceding clause, wherein the preparatory charged particle-optical device is configured to project the preparatory charged particle beam toward the illumination location.
Clause 6. The charged particle-optical apparatus of any preceding clause, wherein the light source is configured to project the light beam toward the illumination location after the preparatory charged particle-optical device projects the preparatory charged particle beam.
Clause 7. The charged particle-optical apparatus of any preceding clause, wherein the illumination location is displaced away from the assessment beam path.
Clause 8. The charged particle-optical apparatus of any preceding clause, wherein the preparatory charged particle-optical device is configured to project the preparatory charged particle beam along the preparatory beam path toward a preparatory location.
Clause 9. The charged particle-optical apparatus of any clause 8, wherein the illumination location is between the preparatory location and the assessment location.
Clause 10. The charged particle-optical apparatus of any clause 8 or 9, wherein a distance between the illumination location and the preparatory location is less that a distance between the illumination location and the assessment location.
Clause 11. The charged particle-optical apparatus of any preceding clause, wherein a distance between the illumination location and the assessment charged particle-optical device is greater than a distance between the assessment location and the assessment charged particle-optical device.
Clause 12. The charged particle-optical apparatus of any preceding clause, wherein a distance between the assessment location and the assessment charged particle-optical device in a direction along the assessment beam path is less than a distance between the illumination location and the preparatory charged particle-optical device in the direction along the assessment beam path.
Clause 13. The charged particle-optical apparatus of any preceding clause, wherein a distance between the assessment location and the assessment charged particle-optical device in a direction along the assessment beam path is less than a distance between the assessment location and the preparatory charged particle-optical device in the direction along the assessment beam path.
Clause 14. The charged particle-optical apparatus of any preceding clause, wherein a distance between the assessment location and the assessment charged particle-optical device is less than a distance between the illumination location and the assessment charged particle-optical device in the direction along the assessment beam path location.
Clause 15. The charged particle-optical apparatus of any preceding clause, wherein a field of view of the assessment charged particle-optical device at the assessment location is wider in a direction across the assessment beam path than a distance between the assessment location and the assessment charged particle-optical device in a direction along the assessment beam path.
Clause 16. The charged particle-optical apparatus of any preceding clause, wherein a preparatory portion is the surface of the sample prepared by the preparatory beam and an assessment portion is the surface of the sample assessed by the assessment beam at the assessment location, wherein the preparatory portion is as least as large as the assessment portion desirably wherein the preparatory portion encompasses the assessment portion, desirably the preparatory portion comprises the preparatory portion.
Clause 17. The charged particle-optical apparatus of clause 16, wherein the preparatory portion corresponds to the field of view of the preparatory beam and the assessment portion corresponds to the field of view of the assessment beam at the assessment location.
Clause 18. The charged particle-optical apparatus of any preceding clause, wherein the assessment location is in a sample plane and the illumination location is in the sample plane.
Clause 19. The charged particle-optical apparatus of any of clauses 1-17, wherein the illumination location is displaced further than the assessment location in a direction along the assessment beam path.
Clause 20. The charged particle-optical apparatus of any preceding clause, wherein the light source is associated with the preparatory charged particle-optical device.
Clause 21. The charged particle-optical apparatus of any clause 20, wherein the light source is integrated with the preparatory charged particle-optical device.
Clause 22. The charged particle-optical apparatus of any preceding clause, wherein at least part of a light beam path along which the light source is configured to project the light beam is parallel to a direction of the preparatory beam path.
Clause 23. The charged particle-optical apparatus of any preceding clause, wherein at least part of a light beam path along which the light source is configured to project the light beam is along at least part of the preparatory beam path.
Clause 24. The charged particle-optical apparatus of any clauses 1-19, wherein the light source is associated with the assessment charged particle-optical device.
Clause 25. The charged particle-optical apparatus of clause 24, wherein the light source is configured to project the light beam when the sample is proximate to the assessment location.
Clause 26. The charged particle-optical apparatus of any clauses 1-19, wherein the light source is comprised in an illumination device between the assessment charged particle device and the preparatory charged particle device.
Clause 27. The charged particle-optical apparatus of clause 26, wherein the illumination device is separate from the assessment charged particle-optical device and the preparatory charged particle-optical device.
Clause 28. The charged particle-optical apparatus of any preceding clause, wherein the preparatory charged particle-optical device is a flooding charged particle-optical device for flooding a surface of a sample with charged particles.
Clause 29. The charged particle-optical apparatus of any preceding clause, wherein the assessment charged particle-optical device and/or the preparatory charged particle-optical device comprises one or more charged particle-optical elements which comprise a microelectromechanical component.
Clause 30. The charged particle-optical apparatus of any preceding clause, wherein the assessment charged particle beam is a beam grid of a plurality of beams.
Clause 31. The charged particle-optical apparatus of any preceding clause, wherein a surface of the assessment charged particle-optical device that is configured to face the assessment location is an array of electron-optical elements for example an array of detectors.
Clause 32. The charged particle-optical apparatus of any preceding clause, comprising a controller configured to control one or more of the assessment charged particle-optical device, the preparatory charged particle-optical device and the light source.
Clause 33. The charged particle-optical apparatus of any preceding clause, further comprising an actuatable stage configured to support a sample.
Clause 34. The charged particle-optical apparatus of clause 33, wherein the actuatable stage is configured to move the sample from the illumination location to the assessment location after the light source has projected the light beam toward the illumination location.
Clause 35. The charged particle-optical apparatus of clause 33 or 34, wherein the actuatable stage is configured to move the sample into the assessment location before the assessment charged particle-optical device is configured to project the assessment charged particle beam toward the assessment location.
Clause 36. The charged particle-optical apparatus of any of clauses 33-35, wherein the actuatable stage is configured to move the sample to the illumination location before the assessment charged particle-optical device is configured to project the assessment charged particle beam toward the assessment location.
Clause 37. A method for assessing a sample at an assessment location, the method comprising: projecting with a preparatory charged particle-optical device a preparatory charged particle beam along a preparatory beam path, the preparatory charged particle beam for preparing a sample for assessment; projecting a light beam toward the sample at an illumination location; and projecting with an assessment charged particle-optical device an assessment charged particle beam along an assessment beam path toward the sample at an assessment location, the assessment charged particle beam for assessing the sample at the assessment location; wherein a locational relationship between the illumination location and the assessment charged particle-optical device is different from a locational relationship between the assessment location and the assessment charged particle-optical device.
Clause 38. A method for assessing a sample at an assessment location, the method comprising: projecting with a preparatory charged particle-optical device a preparatory charged particle beam along a preparatory beam path, the preparatory charged particle beam for preparing a sample for assessment; projecting a light beam toward the sample at an illumination location; and projecting with an assessment charged particle-optical device an assessment charged particle beam along an assessment beam path toward the sample at an assessment location, the assessment charged particle beam for assessing the sample at the assessment location; wherein the light beam is projected toward the sample at the illumination location when the sample is away from the assessment location.
Clause 39. The method of clause 38, wherein the light beam is projected toward the illumination location before the assessment charged particle-optical device projects the assessment charge particle beam toward the assessment location.
Clause 40. The method of clause 38 or 39, wherein the preparatory charged particle-optical device projects the preparatory charged particle beam toward the sample while the light beam is projected toward the illumination location.
Clause 41. The method of clause 40, wherein the light beam is started to be projected toward the sample with the start of the projection of the preparatory charged particle beam toward the sample.
Clause 42. The method of clause 38 or 39, wherein the light beam is projected toward the sample after the projection of the preparatory beam towards the sample has stopped.
Clause 43. The method of any of clauses 38-42, wherein the light beam is started to be projected toward the sample after the start of the projection of the preparatory charged particle beam towards the sample.
Clause 44. The method of any of clauses 38-43, comprising: moving with an actuatable stage the sample from the illumination location to the assessment location after the light beam has been projected toward the sample.
Clause 45. The method of clause 44, wherein the illumination location is in a different plane along a direction of the assessment beam path from the assessment location, wherein desirably the sample is moved between the different planes of the illumination location and the assessment location when moving the sample between the assessment location and the illumination location.
Clause 46. A method for assessing a sample at an assessment location, the method comprising: projecting a preparatory charged particle beam toward a sample for preparing the sample for assessment; projecting a light beam toward the sample; and projecting an assessment charged particle beam along an assessment beam path toward the sample at an assessment location for assessing the sample at the assessment location, wherein the projecting of the light beam is before the sample is at the assessment location.
Clause 47. A charged particle-optical apparatus for assessing a sample at an assessment location, the charged particle-optical apparatus comprising: an assessment charged particle-optical device configured to project an assessment charged particle beam along an assessment beam path toward an assessment location, the assessment charged particle beam for assessing a sample at the assessment location; and a preparatory charged particle-optical device configured to project a preparatory charged particle beam along a preparatory beam path, the preparatory charged particle beam for preparing a sample for assessment; wherein the assessment charged particle-optical device comprises: one or more charged particle-optical elements which comprise a microelectromechanical component and/or an objective lens comprising a plurality of objective lenses for different beams of the assessment charged particle beam.
Clause 48. The charged particle-optical apparatus of clause 48 wherein the different beams are sub-beams. Desirably the sub-beams are derived from the assessment charged particle beam. Desirably the different beams are projected towards the sample. Desirably, the objective lens comprises one more of the charged particle optical elements. Desirably one more of the charged particle-optical elements comprises a detector, for example a detector array desirably comprising an array of detector elements. A detector element may be configured to detect signal particles derived from a different beam of the assessment charged particles from a source of the assessment charged particle device.

## Claims

1. A charged particle-optical apparatus for assessing a sample at an assessment location, the charged particle-optical apparatus comprising:
an assessment charged particle-optical device configured to project an assessment charged particle beam along an assessment beam path toward an assessment location, the assessment charged particle beam for assessing a sample at the assessment location;
a preparatory charged particle-optical device configured to project a preparatory charged particle beam along a preparatory beam path, the preparatory beam for preparing a sample for assessment; and
a light source configured to project a light beam toward the sample at an illumination location away from the assessment location.

2. The charged particle-optical apparatus of claim 1, wherein the light source is configured to project the light beam toward the illumination location before the assessment charged particle-optical device projects the assessment charged particle beam toward the assessment location for assessing a sample at the assessment location.

3. The charged particle-optical apparatus of claim 1 or 2, wherein the preparatory charged particle-optical device is configured to project the preparatory charged particle beam while the light source projects the light beam toward the illumination location.

4. The charged particle-optical apparatus of any preceding claim, wherein the preparatory charged particle-optical device is configured to project the preparatory charged particle beam toward the illumination location.

5. The charged particle-optical apparatus of any preceding claim, wherein the light source is configured to project the light beam toward the illumination location after the preparatory charged particle-optical device projects the preparatory charged particle beam.

6. The charged particle-optical apparatus of any preceding claim, wherein the illumination location is displaced away from the assessment beam path.

7. The charged particle-optical apparatus of any preceding claim, wherein the preparatory charged particle-optical device is configured to project the preparatory charged particle beam along the preparatory beam path toward a preparatory location.

8. The charged particle-optical apparatus of any claim 7, wherein the illumination location is between the preparatory location and the assessment location.

9. The charged particle-optical apparatus of any preceding claim, wherein a distance between the illumination location and the assessment charged particle-optical device is greater than a distance between the assessment location and the assessment charged particle-optical device.

10. The charged particle-optical apparatus of any preceding claim, wherein a distance between the assessment location and the assessment charged particle-optical device in a direction along the assessment beam path is less than a distance between the illumination location and the preparatory charged particle-optical device in the direction along the assessment beam path.

11. The charged particle-optical apparatus of any preceding claim, wherein a distance between the assessment location and the assessment charged particle-optical device in a direction along the assessment beam path is less than a distance between the assessment location and the preparatory charged particle-optical device in the direction along the assessment beam path.

12. The charged particle-optical apparatus of any preceding claim, wherein a distance between the assessment location and the assessment charged particle-optical device is less than a distance between the illumination location and the assessment charged particle-optical device in the direction along the assessment beam path location.

13. The charged particle-optical apparatus of any preceding claim, wherein a field of view of the assessment charged particle-optical device at the assessment location is wider in a direction across the assessment beam path than a distance between the assessment location and the assessment charged particle-optical device in a direction along the assessment beam path.

14. The charged particle-optical apparatus of any preceding claim, wherein a preparatory portion is the surface of the sample prepared by the preparatory beam and an assessment portion is the surface of the sample assessed by the assessment beam at the assessment location, wherein the preparatory portion is as least as large as the assessment portion desirably wherein the preparatory portion encompasses the assessment portion, desirably the preparatory portion comprises the preparatory portion.

15. The charged particle-optical apparatus of any of claims 1-14, wherein the illumination location is displaced further than the assessment location in a direction along the assessment beam path.
